(19) **Europäisches Patentamt / European Patent Office / Office européen des brevets**

(11) **EP 4 700 636 A1**

(12) # EUROPEAN PATENT APPLICATION

(43) Date of publication:
**25.02.2026 Bulletin 2026/09**

(21) Application number: **24195787.7**

(22) Date of filing: **22.08.2024**

(51) International Patent Classification (IPC):
**G06F 30/27** (2020.01)   **B60W 50/02** (2012.01)
**G06F 17/17** (2006.01)   **G06F 17/18** (2006.01)
**G06N 7/01** (2023.01)

(52) Cooperative Patent Classification (CPC):
**G06F 30/27; B60W 50/0205; G06F 17/17;
G06F 17/18; G06N 7/01**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Robert Bosch GmbH
70442 Stuttgart (DE)**

(72) Inventors:
- **Schmidt, Julian
  72072 Tuebingen (DE)**
- **Baslan, Naya
  70178 Stuttgart (DE)**
- **Kerschl, Alexander Ferdinand
  70563 Stuttgart (DE)**
- **Pflueger, Dirk
  70569 Stuttgart (DE)**

(54) **COMPUTER IMPLEMENTED METHOD AND SYSTEM FOR EVALUATION OF AN AUTOMATED DRIVING SYSTEM**

(57)   A computer implemented method for evaluation of an automated driving system is proposed, wherein the system under test generates an output on the basis of collected sensor data, said sensor data parametrically describing a given situation as point in a given parameter space.

Said evaluation method comprises at least the following steps:
• Providing a Sparse Grid (SG) Surrogate Model which is configured to estimate the system output especially in safety critical situations - step 14,
• providing a Gaussian Process (GP) Surrogate Model which is configured to estimate the system output especially in safety critical situations, said GP Surrogate Model using the corresponding estimation of said SG Surrogate Model when estimating the system output for a given point in said parameter space - step 24,
• providing a large test set of points in said parameter space said test set comprising points corresponding to safety critical situations - step 31,
• using said SG Surrogate Model for a SG-estimation of the system output for said test set of points - step 31,
• using said GP Surrogate Model for a GP-estimation of the system output for said test set of points - step 31, and
• determining a probability of failure and/or an uncertainty of said probability of failure on the basis of said GP-estimation of the system output for said test set of points - steps 32, 33.

**Fig. 1**

EP 4 700 636 A1

**Description**

Technical field

Autonomous driving vehicles are on the verge of becoming a reality for public use, although their deployment has encountered delays beyond the initial planned timelines. One of the main reasons for this delay is the incomplete development of safety assessment and testing infrastructure. Currently, there is no guarantee that these vehicles will meet the safety standards outlined in ISO26262. The European Commission has released the EU Regulation 2022/1426 to document the testing and safety requirements that have to be fulfilled before an automated vehicle can be accepted into the streets. Among these requirements are that the system operates in a safe manner and does not cause any unnecessary and foreseeable accidents. Moreover, in the case of extreme cases and dangerous situations, the system must perform at least as good as a competent human driver would behave in order to minimize risk.

Testing autonomous driving technology is a complex challenge and crucial aspect to be considered during development. Traditional testing methods of automated driving systems require driving in real-world traffic and exposure to various scenarios. This raises the question of how many kilometers of test-drives are required to assess the safety of the system. According to recent studies billions of kilometers would be needed to cover a sufficient number of scenarios. However, relying solely on test-drives is neither feasible nor realistic, as it would require hundreds of years of testing.

Therefore, alternative methods for safety assessment are needed.

Prior art

One approach to assess the safety and behavior of autonomous driving systems under various driving conditions uses surrogate models which learn the behavior of the system under test and can simulate the system's behavior under different conditions and scenarios.

Rare event estimation problems have been known throughout the years in different fields. One of the most prominent fields is civil engineering for applications like structure design and load analysis. The current state-of-the-art results for meta-modeling are delivered by the PC-Kriging method, as described in Roland Schöbi, Bruno Sudret and Joe Wiart. Polynomial-chaos-based kriging. International Journal of Uncertainty Quantification, 5(5), 2015.

This two-stage approach combines the global approximation properties of Polynomial Chaos Expansions (PCE) with the ability of Gaussian Processes (Kriging) to capture local variations in the underlying system to create a new meta-modeling technique that outperforms the two individual approaches.

For advancing this state-of-the-art modeling technique, we propose replacing PCE in the first stage meta-modeling approach, with Sparse Grids, as the latter offer a more efficient and adaptive approach to deal with high dimensional input spaces. Sparse Grids were first introduced for the solution of higher-dimensional PDEs by Christoph Zenger. Sparse Grids. In Wolfgang Hackbusch, editor, Parallel Algorithms for Partial Differential Equations, volume 31 of Notes on Numerical Fluid Mechanics, pages 241-251. Vieweg, 1991.

However, according to the invention it has been recognized that Sparse Grids are able to mitigate the curse of dimensionality, which otherwise prohibits the use of grid-based discretization approaches.

Technical background

Main aspect of the present invention is the evaluation of an automated driving (AD) system, i.e. estimating the probability of failure of the AD system under test. Failure of such a system occurs only infrequently with respect to the large distance travelled by the vehicle. Failures are thus labelled as rare events. As more technically defined by James L. Beck and Konstantin M. Zuev. Rare event simulation, 2015, rare events have a low probability of occurrence, usually in the order of $10^{-3}$ or less. The total probability of failure of the system is calculated as defined in Konstantin Althaus, Iason Papaioannou, and Elisabeth Ullmann. Consensus-based rare event estimation, 2023, using Equation 1:

$$P_f = \int_{D_f} f_X(x)dx \qquad (1)$$

Here, $P_f$ indicates the probability of failure, $D_f$ is the failure domain and $f_X$ is the joint probability distribution function of the input vector X. The evaluation of this integral is computationally expensive and analytically intractable. Simplifications through Monte Carlo simulations have been introduced, where the complex integral would simplify to the ratio of the total number of failure cases $n_f$ to the total evaluated ones $n_{MC}$, as shown in Equation 2:

$$P_f = \frac{n_f}{n_{MC}} \qquad (2)$$

The uncertainty in this estimation of $P_f$ using Monte Carlo is calculated using Equation 3:

$$coV = \sqrt{\frac{1-P_f}{P_f \cdot n_{MC}}} \qquad (3)$$

This Equation 3 already gives an indication of the large number of sample evaluations required for a significant uncertainty statement. For example, to achieve an acceptable uncertainty range of 5%, for rare events, whose probability of failure lies in the order 10-3, one would already require around 400000 evaluations of the real simulation, clearly beyond the scope of testing all intended functionality of a system. This shows the necessity of a surrogate model, which can provide a more accurate and cost-effective alternative.

Therefore, the present invention provides a new modelling approach for AD systems in order to accurately and cost-efficiently estimate the probability of failure and to determine the uncertainty of this estimation. This so called adaptive Sparse Grids Kriging (ASGK) approach is a two-stage meta-modeling approach using Sparse Grids in a first stage of surrogate modelling and Gaussian Processes in a second stage of surrogate modelling.

The following paragraphs provide the theoretical background of Sparse Grids. Sparse Grids using hierarchical basis functions are described in Dirk Pflüger, editor. Spatially Adaptive Sparse Grids for High-Dimensional Problems. Verlag Dr. Hut, München, 2010. In their simplest form, they utilize piece-wise d-linear function spaces on the domain $\Omega = [0, 1]^d$ for regular discretizations with mesh width $h_l = 2^{-l}$ in dimension $l$. In 1 D, the standard hat-function

$$\varphi(x) = max(1 - |x|, 0) \qquad (4)$$

is used. It is extended to hierarchical basis functions $\varphi_{l,i}$ on level $l$ and index i via scaling and translation as

$$\varphi_{l,i}(x) = \varphi(2^l x - i) \qquad (5)$$

and to d dimensions via a tensor product approach,

$$\varphi_{l,i}(x) = \prod_{j=1}^{d} \varphi_{l_j i_j}(x_j) \qquad (6)$$

with level and index vectors l, i. Sparse Grids approximate functions using a weighted sum of hierarchical basis functions, in the univariate case (1 D) as $f_l = \sum_{i=0}^{2^l} c_{l,i}\varphi_{l,i}$ and in the multivariate case as $f_l = \sum_{i=0}^{2^l} c_{l,i}\varphi_{l,i}$.

In a preferred embodiment of the invention smooth hierarchical B-spline basis functions of degree p = 3 are used, as introduced in Julian Valentin. B-Splines for Sparse Grids: Algorithms and Application to Higher-Dimensional Optimization. PhD thesis, University of Stuttgart, Germany, 2019. They are based on the template B-spline

$$b^p(x) = \frac{x}{p} b^{p-1}(x) + \frac{p+1-x}{p} b^{p-1}(x - 1) \qquad (7)$$

$$b^0(x) = \{1, if \ 0 \le x \le 1; \ 0, otherwise\} \qquad (8)$$

with the corresponding hierarchical B-spline basis functions as

$$\varphi_{l,i}^p(x) = b^p(2^l x + \frac{p+1}{2} - i) \qquad (9)$$

The following paragraphs provide some theoretical background of Gaussian Processes as they are used in the second stage of the surrogate modeling technique proposed with the present invention.

Gaussian Processes are a very powerful class of probabilistic non-parametric models. They are a generalization of Gaussian distributions over functions and have been widely used in machine learning techniques, particularly to create flexible surrogate models that can generalize well to a large set of data. Gaussian Processes are defined through their mean function $m(x)$ and covariance function $k(x, x')$:

$$\bar{m}(x) = m(x) + (k_{xX} + \sigma^2 I_n)^{-1}(Y - m_X) \qquad (10)$$

$$\bar{k}(x,x') = k(x,x') - k_{xX}(k_{XX} + \sigma^2 I_n)^{-1} k_{Xx'} \qquad (11)$$

where $\overline{m}(x)$ and $\bar{k}(x, x')$ are the posterior mean and covariance functions, $m(x)$ and $k(x, x')$ are the prior mean and covariance functions.

$X = (x_1, x_2, \ldots , x_n)$ is the set of input data points,
$Y = (y_1, y_2, \ldots , y_n)$ is the set of output values.

Disclosure of the invention

The invention is directed to a computer implemented method for evaluation of an automated driving system, wherein the system under test generates an output on the basis of collected sensor data, said sensor data parametrically describing a given situation as point in a given parameter space. According to the invention said evaluation method comprises at least the following steps:

a) providing a Sparse Grid (SG) Surrogate Model which is configured to estimate the system output especially in safety critical situations,
b) providing a Gaussian Process (GP) Surrogate Model which is configured to estimate the system output especially in safety critical situations, said GP Surrogate Model using the corresponding estimation of said SG Surrogate Model when estimating the system output for a given point in said parameter space,
c) providing a large test set of points in said parameter space said test set comprising points corresponding to safety critical situations,
d) using said SG Surrogate Model for a SG-estimation of the system output for said test set of points,
e) using said GP Surrogate Model for a GP-estimation of the system output for said test set of points, and
f) determining a probability of failure and/or an uncertainty of said probability of failure on the basis of said GP-estimation of the system output for said test set of points.

Accordingly, the invention proposes to use a two-stage Surrogate Model of an AD system under test to estimate the system output for a large test set of points which represents all sorts of situations and, thus, also comprises safety critical situations. The estimations of the system output for such a large test set of points are then used to determine a probability of failure and/or an uncertainty of said probability of failure as basis for an evaluation of the AD system under test. Main aspect of the invention is the use of said two-stage Surrogate Model which is referred to as Adaptive Sparse Grids Kriging (ASGK) Surrogate Model in the following. According to the invention the first stage of the ASGK Surrogate Model is realized by a Sparse Grid and the second stage is realized by a Gaussian Process which uses the SG-estimation to generate a GP-estimation of the system output.

One further important aspect of the invention is the configuration of a Sparse Grid Surrogate Model as first stage of such an ASGK Surrogate Model. Therefore, a computer implemented method for configuration of a Sparse Grid (SG) Surrogate Model is proposed, comprising at least the following steps:

a) providing an SG, said SG covering a given parameter space of test situations with a given number of grid points,
b) adaptively refining said SG by using the system under test to determine the relevance of each grid point and, depending on the determined relevance,

i. selecting at least one grid point,
ii. creating at least one child point of said selected grid point and
iii. adding said child point as additional grid point to said SG;

c) generating system output for all grid points of the thus adaptively refined SG, and
d) providing at least one interpolation function which is designed to interpolate the system output for said grid points in order to estimate the system output for points in said parameter space other than grid points.

Preferably, the relevance of each grid point is determined by

i. generating the corresponding system output for all grid points,
ii. determining, for each grid point, a proximity of the corresponding system output to a safety critical boundary, which separates failure system outputs from safe system outputs, and
iii. ranking all grid points according to their proximity to the safety critical boundary.

Accordingly, the invention proposes to adaptively refine an initial Sparse Grid covering the parameter space of the AD system under test. Therefore, the AD system under test is used to determine the system output for the given grid points. Then, the grid points are prioritized according to their proximity to a safety critical boundary. The closer a grid point is to said boundary the higher is its priority to be refined. Thus, this method focuses on refining given grid points in safety critical regions of the parameter space in order to improve overall global accuracy of the SG Surrogate Model. A preferred refinement criterion that ranks points based on their proximity to a safety critical boundary is defined as follows:

$$\frac{1}{1+|\alpha_j - thr|} \tag{12}$$

Here $\alpha_j$ is the system output for a given point $j$. The safety critical boundary is given by a threshold *thr.*

In a preferred embodiment of the claimed method for configuration of a SG Surrogate Model the step b) of adaptively refining said SG is repeated a given number of times in order to iteratively refine said SG. In each iteration step a given number of grid points are selected to create child points. Thus, it is possible to focus the accuracy of the SG Surrogate Model on selected regions of the parameter space. Also, the number of child points to be created per selected grid point can be chosen. Preferably, that number of child points is a maximum of 2d points in hierarchical structure from each existing grid point.

The SG Surrogate Model uses at least one interpolation function to interpolate the system output for all grid points - initial grid points and created child points - in order to estimate the system output for points in said parameter space other than grid points. As already mentioned above, a preferred embodiment of the invention uses a B-spline function as interpolation function, especially a smooth hierarchical B-spline basis function of degree p=3. But it should be mentioned here that also the use of other interpolation functions is in the scope of the present invention.

Another important aspect of the invention is the configuration of a Gaussian Process Surrogate Model as second stage of an ASGK Surrogate Model. Therefore, a computer implemented method for configuration of a Gaussian Process (GP) Surrogate Model is proposed, comprising at least the following steps:

 a) Providing an initial GP Surrogate Model at least comprising

  i. a SG surrogate Model as mean prior function, wherein said SG Surrogate Model is configured as described above, and
  ii. a covariance function with a kernel depending on an underlying set of input points, and
  iii. using the system under test to determine a deviation between the system outputs and the SG-estimations for given input points;

 b) providing an acquisition function to identify points in proximity to a safety critical boundary, which separates failure system outputs from safe system outputs;
 c) complementing a given set of input points by the following steps:

  i. generating GP-estimations for said input points,
  ii. optimizing said acquisition function for each input point, thus identifying additional input points and complementing said set of input points with said additional input points,
  iii. modifying the parameters of said covariance function according to the thus complemented set of input points and
  iv. determining the deviation between the system outputs and the SG-estimations for said complemented set of input points;
  v. repeating steps i to iv until a given stopping criterion is reached.

According to the invention an adaptively refined SG Surrogate Model is incorporated in an initial GP Surrogate Model as mean prior function. Therewith, the invention deviates from a standard Gaussian Process with a zero mean prior function because it has been recognized that using an adaptively refined SG Surrogate Model as mean prior function improves the overall performance of the GP Surrogate Model for estimating the output of the system under test.

Consequently, in order to obtain an ASGK Surrogate Model according to the invention the surrogate modeling process is divided into two stages. In the first stage, a SG Surrogate Model is configured and adaptively refined as described in the preceding paragraphs. Then, in the second stage, this SG meta-model is used as the mean prior function term, $m(x)$, when applying the GP equations, first, in order to refine the GP Surrogate Model and, second, when estimating the system output with the resulting ASGK surrogate model.

Refinement of the initially provided GP Surrogate Model is done iteratively by complementing an initial given set of input points covering the parameter space of the AD system under test and, thus, modifying the two components of the GP Surrogate Model: the covariance function and the deviation between the system outputs and the SG-estimations for the complemented set of input points. According to the invention the given set of input points is complemented by points in proximity to a safety critical boundary, which separates failure system outputs from safe system outputs, thus guiding the evaluations towards the regions of interest, namely the boundary separating safety and failure cases. Such points are identified using a so-called acquisition function.

In a preferred embodiment of the invention said acquisition function takes into account a variance of the GP-estimation for a given input point and a proximity of the corresponding GP-estimation to said safety critical boundary. Such an acquisition function may be defined as

$$U(x) = \frac{|\overline{m}(x) - thr|}{\sigma(x)} \tag{13}$$

The U-function $U(x)$ takes into account both the variance $\sigma(x)$ the GP-estimation for a given input point $x$ and the relative absolute distance between the corresponding GP-estimation $\overline{m}(x)$ to said safety critical boundary represented by a safety threshold $thr$. By minimizing this acquisition function (13),

$$x^* = argmin_x \left| \frac{\overline{m}(x) - thr}{\sigma(x)} \right| \tag{14}$$

the algorithm focuses on sampling points $x^*$ closer to the boundary surface, thereby enhancing the accuracy in that region. Thus, the most crucial points $x^*$ are selected to complement the set X of input points of the GP Surrogate Model $X \leftarrow \{X, x^*\}$.

In a preferred embodiment of the invention the grid points of the adaptively refined SG Surrogate Model are used as starting set of input points for the configuration of the GP Surrogate Model, since these grid points cover the parameter space of the AD system under their distribution is already adapted to the safety critical regions of the parameter space.

There are different stopping criterions for the iterative refinement of the initial GP surrogate Model, which may be applied together or alternatively. So, one stopping criterion might be a given number of iterations for complementing a given starting set of input points. To apply another stopping criterion a coefficient of variation coV is determined after each iteration step for complementing the given starting set of input points. This stopping criterion is defined by a threshold $\varepsilon$ for said coefficient of variation coV meaning that the refinement steps are repeated as long as the coefficient of variation stays above said threshold $\varepsilon$.

The refinement process of the initial GP Surrogate Model results in an ASGK Surrogate Model which is the core of the present invention. The foregoing paragraphs state that the underlying two-stage meta-modeling approach starts with using Sparse Grids to build a surrogate model that will then be used to replace the mean prior function of the Gaussian Process. Furthermore, these paragraphs show that the adaptive properties of such an ASGK Surrogate Model are due to adaptive refinement of the SG Surrogate Model and active learning of the GP Surrogate Model by complementing the underlying set of input points.

Embodiments of the invention will be discussed in more detail with reference to the following figures. The figures show:

Fig. 1 a flowchart illustrating a computer implemented method for evaluation of an AD system using ASGK Surrogate Model of said AD system, wherein said flowchart also illustrates the configuration of said ASGK Surrogate Model;

Fig. 2a an initial Sparse Grid covering a 2D-parameter space of situations to be handled by an AD-system and

Fig. 2b said Sparse Grid adaptively refined according to the invention;

Fig. 3a a Birds-Eye-View (BEV) of a cut-out scenario and

Fig. 3b the corresponding 2D-parameter space for that cut-out scenario with parameters, speed of leading vehicle "leading_vehicle_speed" and lane change by distance to leading vehicle in front "lane_change_distance_lead_to_in_front".

Description of the embodiments

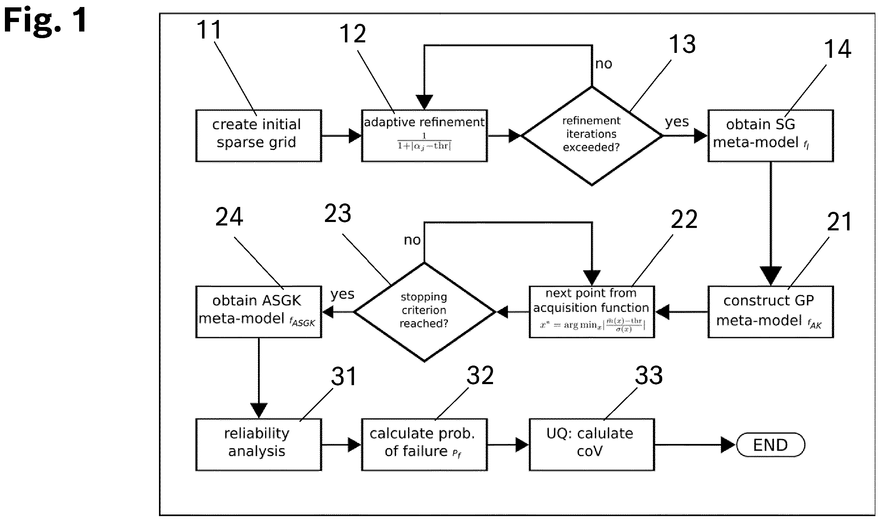

The Flowchart of **Fig. 1** illustrates a framework for evaluating an AD system which generates an output on the basis of collected sensor data, wherein said sensor data parametrically describes a given situation as point in a given parameter space. The framework shown in Fig. 1 represents one possible implementation of the approach proposed by the present invention.

The first stage of the proposed two-stage meta-modelling process starts with creating a static Sparse Grid in step 11. This initial Sparse Grid is covering the parameter space of test situations for the AD system under test and comprises a given number of grid points. B-Spline basis functions are used to interpolate between the output of the AD system under test for these grid points, thus forming a SG Surrogate Model for the AD system under test. This initial SG Surrogate Model is adaptively refined by repeating step 12 in a first loop of the algorithm until a stopping criterion is reached. This stopping criterion might be a predefined number of iterations which are counted in step 13. Adaptive refinement is done by ranking the grid points according to the proximity of their corresponding system output to a boundary surface that separates the failure system outputs from the safe system outputs. Here, the refinement criterion that ranks points based on their proximity to a safety critical boundary is defined as:

$$\frac{1}{1+|\alpha_j - thr|} \qquad (12)$$

wherein $\alpha_j$ is the system output for a given point j and the safety critical boundary is given by a threshold *thr*. Depending on the ranking child points are generated for selected grid points and these child points are added as new grid points to the SG Surrogate Model. This process results in an adaptively refined SG Surrogate Model $f_l$ in step 14.

In the second stage of the proposed two-stage meta-modelling process an ASGK meta model $f_{ASGK}$ is configured. Therefore, in step 21 an initial Gaussian Process Surrogate Model $f_{AK}$ is constructed with the adaptively refined SG Surrogate Model obtained in step 14 as its mean prior function. The index characters *AK* of the initial Gaussian Process Surrogate Model $f_{AK}$ stand for Adaptive Kriging. Further adaptive refinement of this initial Gaussian Process Surrogate Model $f_{AK}$ is done iteratively in a second loop of the algorithm through active learning in step 22. There the U-function $U(x)$ (13) is used as acquisition function to identify points $x^*$ in proximity to the safety critical boundary and complement the set $X$ of input points of the GP with these points $x^*$.

The U-function $U(x)$ takes into account both the variance $\sigma(x)$ the GP-estimation for a given input point $x$ and the relative absolute distance between the corresponding GP-estimation $\overline{m}(x)$ to said safety critical boundary represented by a safety threshold *thr*. By minimizing this acquisition function (13),

$$x^* = argmin_x \left| \frac{\overline{m}(x) - thr}{\sigma(x)} \right| \qquad (14)$$

the algorithm focuses on sampling points $x^*$ closer to the boundary surface, thereby enhancing the accuracy in that region. Thus, the most crucial points $x^*$ are selected to complement the set $X$ of input points of the GP Surrogate Model $f_{AK}$: $X \leftarrow \{X, x^*\}$.

Adaptive refinement of initial Gaussian Process Surrogate Model $f_{AK}$ in step 22 is repeated in the second loop of the algorithm until a given a stopping or convergence criterion is reached or when a predefined maximum number of iterations is exceeded. This is checked in step 23. The result of this iteration process is an adaptively refined GP Surrogate Model $f_{ASGK}$ obtained in step 24.

Therewith the two-stage meta modelling process is completed and the resulting Surrogate Model $f_{ASGK}$ can be used for reliability analysis of the AD system under test in step 31. In step 31 the Surrogate Model $f_{ASGK}$ is used to estimate the output of the system under test for a large test set S of points in the parameter space of the AD system under test, wherein said test set S comprises all sorts of situation and especially also points corresponding to safety critical situations. determining a probability of failure and/or an uncertainty of said probability of failure on the basis of said GP-estimation of the system output for said test set $S$ of points. In steps 32 and 33 the probability of failure and the coefficient of variation are calculated over said test set S as basis for the evaluation of the AD system under test.

Another description of the algorithm shown in Fig. 1 is given below:

Adaptive Sparse Grids Kriging:

**Require:** $S, X, f, thr, \epsilon$

Create SG meta-model $f_l$ using B-Spling Sparse Grid

**while** number of refinements not exceeded **do**

Rank grid points according to $\dfrac{1}{1+|\alpha_j - thr|}$

Refine $f_l$ according to rank

**end while**

Create $f_{ASGK}$ using $f_l$ as its prior

**while** stopping criterion not reached **do**

Calibrate $f_{ASGK}$

Minimize probability of misclassification

Obtain next most informative point from acq. fun.

$$x^* = argmin_x \left| \frac{m(x) - thr}{\sigma(x)} \right|$$

$$X \leftarrow \{X, x^*\}$$

**end while**

**Output** $f_{ASGK}$

Reliability analysis using $f_{ASGK}$

Compute probability of failure $P_f$ over $S$

Compute coefficient of variation $coV$

**Output:** $P_f$, $coV$

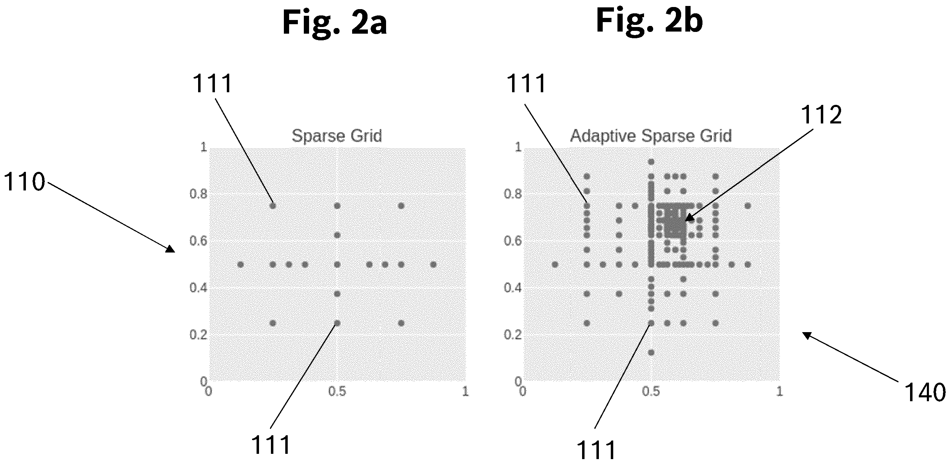

**Fig. 2a** shows an initial Sparse Grid 110 as provided in step 11 of the algorithm described in connection with Fig 1. This initial Sparse Grid 110 covers a 2D-parameter space of situations to be handled by an AD system under test and comprises a given number of initial grid points 111.

**Fig. 2b** shows an adaptive Sparse Grid 140 which is the result of adaptive refinement starting from initial Sparse Grid 110 as described in connection with steps 12 and 13 of the algorithm shown in Fig. 1. Fig. 2b illustrates that the adaptive Sparse Grid comprises all of the initial grid points 111 and additional grid points 112 generated as child points of some selected initial grid points 111.

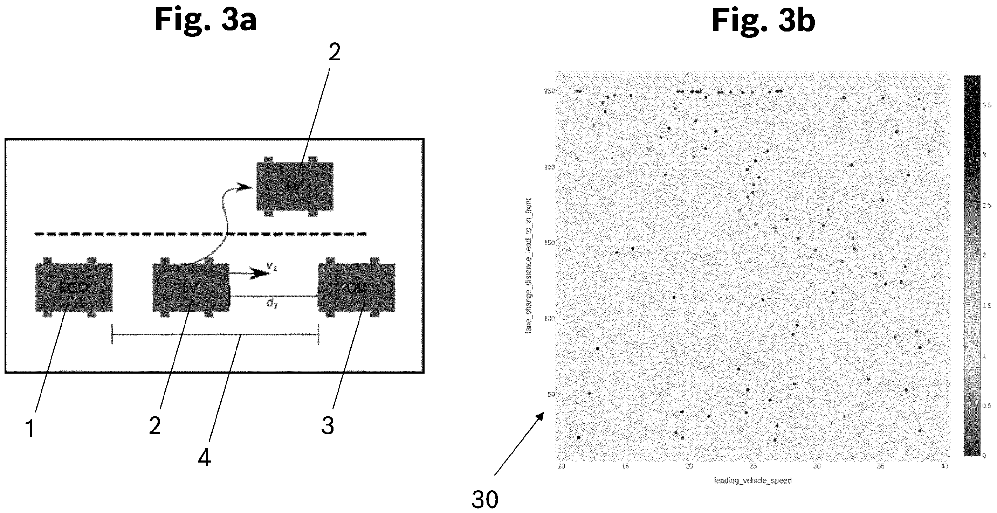

**Fig. 3a is** a Birds-Eye-View (BEV) representation of a cut-out scenario with an ego vehicle driving on the right lane of a two-lane road following a leading vehicle 2. This leading vehicle 2 is driving with speed $v_1$ and has a distance $d_1$ to an in-front vehicle 3. The leading vehicle 2 is about to cut out on the left lane in order to overtake the in-front vehicle 3. As KPI for an AD system of the ego vehicle 1 which is designed to handle such cut-out scenarios a critical safety distance 4 is indicated in Fig. 3a.

In order to evaluate the AD system as proposed with the present invention the scenario given in Fig. 3a is described by the two parameters speed $v_1$ of the leading vehicle 2 (leading_vehicle_speed) and distance $d_1$ to the in-front vehicle 3 (lane-change_distance_lead_to_in_front). **Fig. 3b** shows the corresponding 2D-parameter space 30. Every point in this parameter space 30 represents a cut-out scenario with the corresponding parameter constellation.

Using the ASGK Surrogate Model as proposed by the present invention permits reliable estimation of the system output for a large set of these points and consequently a credible safety evaluation of the AD system under test.

## Claims

1. Computer implemented method for evaluation of an automated driving system, wherein the system under test generates an output on the basis of collected sensor data, said sensor data parametrically describing a given situation as point in a given parameter space,

said evaluation method comprising at least the following steps:

a) providing a Sparse Grid (SG) Surrogate Model which is configured to estimate the system output especially in safety critical situations - step 14,

b) providing a Gaussian Process (GP) Surrogate Model which is configured to estimate the system output especially in safety critical situations, said GP Surrogate Model using the corresponding estimation of said SG Surrogate Model when estimating the system output for a given point in said parameter space - step 24,

c) providing a large test set of points in said parameter space said test set comprising points corresponding to safety critical situations - step 31,

d) using said SG Surrogate Model for a SG-estimation of the system output for said test set of points - step 31,

e) using said GP Surrogate Model for a GP-estimation of the system output for said test set of points - step 31, and

f) determining a probability of failure and/or an uncertainty of said probability of failure on the basis of said GP-estimation of the system output for said test set of points - steps 32, 33.

2.  Computer implemented method for configuration of a Sparse Grid (SG) Surrogate Model to estimate the output of an automated driving system, wherein the system under test generates an output on the basis of collected sensor data, said sensor data parametrically describing a given situation as point in a given parameter space, said configuration method comprising at least the following steps:

    a) providing an SG, said SG covering a given parameter space of test situations with a given number of grid points,

    b) adaptively refining said SG by using the system under test to determine the relevance of each grid point and, depending on the determined relevance,

        i. selecting at least one grid point,

        ii. creating at least one child point of said selected grid point and

        iii. adding said child point as additional grid point to said SG;

    c) generating system output for all grid points of the thus adaptively refined SG, and

    d) providing at least one interpolation function which is designed to interpolate the system output for said grid points in order to estimate the system output for points in said parameter space other than grid points.

3.  Method according to claim 2, wherein the relevance of each grid point is determined by

        i. generating the corresponding system output for all grid points,

        ii. determining, for each grid point, a proximity of the corresponding system output to a safety critical boundary, which separates failure system outputs from safe system outputs, and

        iii. ranking all grid points according to their proximity to the safety critical boundary.

4.  Method according to anyone of the claims 2 or 3, wherein the step of adaptively refining said SG is repeated a given number of times in order to iteratively refine said SG.

5.  Method according to anyone of the claims 2 to 4, wherein in each step of adaptively refining said SG a given number of grid points are selected and/or a given number of child points per selected grid point are created.

6.  Method according to anyone of the claims 2 to 5, wherein a B-spline function is provided as interpolation function, especially a smooth hierarchical B-spline basis function of degree p=3.

7.  Computer implemented method for configuration of a Gaussian Process (GP) Surrogate Model to estimate the output of an automated driving system, wherein the system under test generates an output on the basis of collected sensor data, said sensor data parametrically describing a given situation as point in a given parameter space, said configuration method comprising at least the following steps:

    a) Providing an initial GP Surrogate Model at least comprising

        i. a SG surrogate Model, configured according to anyone of preceding claims 2 to 6, as mean prior function and

        ii. a covariance function with a kernel depending on an underlying set of input points, and

        iii. using the system under test to determine a deviation between the system outputs and the SG-estimations for given input points;

    b) providing an acquisition function to identify points in proximity to a safety critical boundary, which separates failure system outputs from safe system outputs,

c) complementing a given set of input points by the following steps:

    i. generating GP-estimations for said input points,
    ii. optimizing said acquisition function for each input point, thus identifying additional input points and complementing said set of input points with said additional input points,
    iii. modifying the parameters of said covariance function according to the thus complemented set of input points and
    iv. determining the deviation between the system outputs and the SG-estimations for said complemented set of input points;
    v. repeating steps i to iv until a given stopping criterion is reached.

8. Method according to claim 7, wherein said acquisition function takes into account a variance of the GP-estimation for a given input point and a proximity of the corresponding GP-estimation to said safety critical boundary.

9. Method according to claim 7 or 8, wherein the grid points of said SG Surrogate Model are used as starting set of input points.

10. Method according to anyone of the preceding claims 7 to 9, wherein said stopping criterion is a given number of iterations for complementing a given starting set of input points.

11. Method according to anyone of the preceding claims 7 to 10, wherein after each iteration step for complementing the given starting set of input points a coefficient of variation coV is determined and said stopping criterion is defined by a threshold $\varepsilon$ for said coefficient of variation coV.

12. Computer implemented test system, which is configured to carry out the method for evaluation of an automated driving system according to claim 1.

13. Computer implemented system, which is configured to carry out the method for configuration of a Sparse Grid (SG) Surrogate Model according to any one of the claims 2 to 6.

14. Computer implemented system, which is configured to carry out the method for configuration of a Gaussian Process (GP) Surrogate Model according to any one of the claims 7 to 11.

# Fig. 1

11 create initial sparse grid

12 adaptive refinement $\frac{1}{1+|\alpha_j - \mathrm{thr}|}$

13 refinement iterations exceeded? — no / yes

14 obtain SG meta-model $f_l$

21 construct GP meta-model $f_{AK}$

22 next point from acquisition function $x^* = \arg\min_x \left| \frac{\hat{m}(x) - \mathrm{thr}}{\sigma(x)} \right|$

23 stopping criterion reached? — no / yes

24 obtain ASGK meta-model $f_{ASGK}$

31 reliability analysis

32 calculate prob. of failure $P_f$

33 UQ: calulate coV

END

Fig. 2a

Fig. 2b

EP 4 700 636 A1

**Fig. 3b**

**Fig. 3a**

Europäisches
Patentamt

European
Patent Office

Office européen
des brevets

# EUROPEAN SEARCH REPORT

**Application Number**

EP 24 19 5787

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BASLAN NAYA ET AL: "TOWARDS RELIABLE AUTOMATED DRIVING SYSTEMS: SURROGATE MODELING USING SPARSE GRIDS AND GAUSSIAN PROCESSES", 5TH INTERNATIONAL CONFERENCE ON UNCERTAINTY QUANTIFICATION IN COMPUTATIONAL SCIENCES AND ENGINEERING, [Online] 14 June 2023 (2023-06-14), pages 222-236, XP093232768, DOI: 10.7712/120223.10334.20319 ISBN: 978-618-58-2702-1 Retrieved from the Internet: URL:https://www.eccomasproceedia.org/confe rences/thematic-conferences/uncecomp-2023/ 10334> [retrieved on 2024-12-10] * the whole document * | 1-14 | INV. G06F30/27 B60W50/02 G06F17/17 G06F17/18 G06N7/01 |
| A | WO 2023/187117 A1 (FIVE AI LTD [GB]) 5 October 2023 (2023-10-05) * paragraph [0010] - paragraph [0165]; figures 1A, 1B, 1C, 3A, 4B, 4C, 6, 11 * | 1-14 | TECHNICAL FIELDS SEARCHED (IPC) |
| A | US 2019/179738 A1 (HAWTHORNE ROBERT C [US] ET AL) 13 June 2019 (2019-06-13) * paragraph [0060] - paragraph [0090]; figures 9, 11 * | 1-14 | G06F G06N B60W |

-/--

The present search report has been drawn up for all claims

| Place of search | Date of completion of the search | Examiner |
|---|---|---|
| Munich | 16 December 2024 | Lindner, Anja |

EPO FORM 1503 03.82 (P04C01)

page 1 of 2

Europäisches
Patentamt

European
Patent Office

Office européen
des brevets

# EUROPEAN SEARCH REPORT

**Application Number**

EP 24 19 5787

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TEIXEIRA RUI ET AL: "Adaptive approaches in metamodel-based reliability analysis: A review", STRUCTURAL SAFETY, ELSEVIER, AMSTERDAM, NL, vol. 89, 28 November 2020 (2020-11-28), XP086429059, ISSN: 0167-4730, DOI: 10.1016/J.STRUSAFE.2020.102019 [retrieved on 2020-11-28] * pages 5-11, section 3 * ----- | 1-14 | |
| A | GANGOPADHYAY BRITI ET AL: "Identification of Test Cases for Automated Driving Systems Using Bayesian Optimization", 2019 IEEE INTELLIGENT TRANSPORTATION SYSTEMS CONFERENCE (ITSC), IEEE, 27 October 2019 (2019-10-27), pages 1961-1967, XP033668428, DOI: 10.1109/ITSC.2019.8917103 [retrieved on 2019-11-27] * pages 1961-1965, section I and III * ----- | 1-14 | |
|  |  |  | TECHNICAL FIELDS SEARCHED (IPC) |

The present search report has been drawn up for all claims

| Place of search | Date of completion of the search | Examiner |
|---|---|---|
| Munich | 16 December 2024 | Lindner, Anja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

Europäisches
Patentamt

European
Patent Office

Office européen
des brevets

**Application Number**

EP 24 19 5787

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

The Search Division considers that the present European patent application does not comply with the requirements of unity of invention and relates to several inventions or groups of inventions, namely:

1. claims: 1-14

   All claims searched

1.1. claims: 1, 12

   Group I: Method for determining a probability of failure of an automated driving system

1.2. claims: 2-11, 13, 14

   Group II: Method for configuring a sparse grid surrogate model to estimate the output of an automated driving system
   ---

Please note that all inventions mentioned under item 1, although not necessarily linked by a common inventive concept, could be searched without effort justifying an additional fee.

## ANNEX TO THE EUROPEAN SEARCH REPORT
## ON EUROPEAN PATENT APPLICATION NO.

EP 24 19 5787

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2024

| Patent document cited in search report | Publication date | Patent family member(s) | Publication date |
|---|---|---|---|
| WO 2023187117 A1 | 05-10-2023 | NONE | |
| US 2019179738 A1 | 13-06-2019 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ROLAND SCHÖBI** ; **BRUNO SUDRET** ; **JOE WIART**. Polynomial-chaos-based kriging. *International Journal of Uncertainty Quantification*, 2015, vol. 5 (5)
- Parallel Algorithms for Partial Differential Equations. **CHRISTOPH ZENGER** ; **SPARSE GRIDS**. Notes on Numerical Fluid Mechanics. Vieweg, 1991, vol. 31, 241-251
- **JAMES L. BECK** ; **KONSTANTIN M. ZUEV**. *Rare event simulation*, 2015
- **KONSTANTIN ALTHAUS** ; **LASON PAPAIOAN-NOU** ; **ELISABETH ULLMANN**. *Consensus-based rare event estimation*, 2023
- B-Splines for Sparse Grids: Algorithms and Application to Higher-Dimensional Optimization. **JULIAN VALENTIN**. PhD thesis. University of Stuttgart, 2019